# FASCICULE DE BREVET EUROPEEN

(11) **EP 0 556 136 B1**
(45) Date de publication et mention de la délivrance du brevet: **27.03.1996**
(21) Numéro de dépôt: 93420057.7
(22) Date de dépôt: 09.02.1993
(51) Int. Cl.: H01G 9/04, C23C 14/06

(54) **Feuille pour électrode de condensateur électrolytique et procédé de fabrication**
Elektrodenfolie für Elektrolytkondensator und Herstellungsverfahren
Electrode foil for electrolytic capacitor and process of manufacture

(30) Priorité: 14.02.1992 FR 9201899
(43) Date de publication de la demande: 18.08.1993
(73) Titulaire: SATMA, F-38570 Goncelin (FR)
(72) Inventeur: Allegret, Francis, F-38570 Goncelin (FR); Benmalek, Mohamed, F-38400 St Martin d'Heres (FR); Gariel, Emmanuel, F-38700 Corenc (FR)
(74) Mandataire: Mougeot, Jean-Claude

(56) Documents cités:
- GB-A- 2 056 503
- US-A- 5 055 319

## Description

### DOMAINE TECHNIQUE DE L'INVENTION.-

L'invention est relative à une feuille pour électrode de condensateur électrolytique ayant une capacité électrique accrue pouvant atteindre une valeur supérieure à 300.000 microfarads/dm et à un procédé de fabrication de la dite feuille.

### ETUDE DE L'ART ANTERIEUR.-

L'homme du métier de la fabrication des condensateurs électrolytiques, notamment constitués par des feuilles en aluminium, sait que pour obtenir une capacité accrue, il doit augmenter la surface des électrodes. D'où la mise au point de toute une série de types de gravure de la dite feuille destinés à atteindre ce but.

Le plus souvent, le type de gravure est obtenu par une attaque chimique ou électrochimique qui rend la surface de la feuille rugueuse et/ou poreuse.

Plus récemment, on s'est tourné vers une autre technique qui consiste à déposer par une voie physique un film métallique sur la feuille afin de développer ladite porosité ce qui a permis d'améliorer la capacité tout en évitant le recours à des bains d'attaque mettant en oeuvre des produits chimiques plus ou moins nocifs, corrosifs ou présentant des nuisances pour l'environnement.

Dans ce procédé de revêtement comme dans celui du gravage, la feuille obtenue est alors soumise à un traitement dit de formation et/ou de stabilisation chimique ou électrochimique mettant en oeuvre un électrolyte et destiné(s) à éviter une dégradation de son état de surface sous l'action des agents extérieurs et par suite à maintenir la capacité du condensateur dans le temps.

Dans le domaine du revêtement, on peut citer, par exemple, l'USP 4,309,810 qui enseigne un condensateur électrolytique formé d'un substrat en métal ou en matière plastique revêtu par évaporation sous vide d'un dépôt soit d'aluminium soit de tantale soit d'un alliage de plusieurs métaux.

Le dépôt obtenu est poreux et formé d'un alignement de colonnes de cristaux de métal ; mais, l' introduction d'une trace d'oxygène dans la chambre de dépôt sous vide a pour effet de réduire les dimensions des cristaux déposés et de provoquer une certaine ramification des dits cristaux.

Plus précisément, ce brevet revendique : " Un procédé d'obtention de condensateur comportant comme étapes :
- mettre en oeuvre un substrat présentant une surface,
- alimenter une source de chaleur en un métal anodisable provenant d'un dévidoir de fil,
- évaporer le dit métal pour former une vapeur métallique,
- déposer la dite vapeur métallique sur la surface dudit substrat sous un angle d'incidence inférieur à 60 degrés et en présence d'oxygène à une pression partielle n'excédant pas 10⁻⁴ Torr ( 0,0133 Pascal ) de manière à obtenir un revêtement métallique poreux,
- anodiser la surface du revêtement poreux,
- fournir un contact électrique à la dite surface anodisée,
- et enrouler le dit substrat portant le dit revêtement poreux anodisé sous la forme du condensateur."

Dans un exemple d'application, il est précisé qu'une feuille d'aluminium de 10 micromètres d'épaisseur a été revêtue d'un film poreux de 6 micromètres d'épaisseur par évaporation d'aluminium dans une enceinte sous vide.

Après anodisation de ce film poreux dans une solution à 4% en poids d'acide borique et sous une tension de formation de 200 V, la capacité de la feuille d'aluminium par unité de surface était de 96 microfarads par dm.

### PROBLEME POSE.

Le problème sans cesse posé dans le domaine des électrodes de condensateurs électrolytiques, que ce soit pour l'anode ou la cathode, c'est celui de leur capacité électrique par unité de surface. En effet, plus cette capacité spécifique est grande, plus, à capacité totale égale, la dimension des électrodes peut être réduite.

Cela permet, outre une diminution du prix de revient, une miniaturisation des condensateurs et leur application dans des utilisations où la réduction de l'encombrement et du poids sont recherchés.

Comme la voie du revêtement d'un substrat avec de l'aluminium suivi d'une formation et/ou d'une stabilisation a permis de faire des progrès du point de vue capacité électrique, la demanderesse a pensé que dans cette même voie, il était possible d'apporter des améliorations substantielles et d'atteindre des valeurs de capacité beaucoup plus grandes que celles réalisées jusqu'à présent, notamment avec des épaisseurs de revêtement beaucoup plus faibles et donc d'un prix de revient plus bas.

Elle a trouvé que cette amélioration nécessitait la présence d'un dépôt ayant une composition et une structure particulière qui adhère correctement au substrat, ce dépôt devant, par ailleurs, également posséder une stabilité convenable dans le temps, notamment vis à vis des agents extérieurs, de manière à maintenir la capacité dans le temps.

### EXPOSE DE L'INVENTION.-

L'invention consiste en une feuille pour électrode de condensateur electrolytique formée d'un substrat conducteur de l'électricité optionellement rendu rugueux, revêtu par vaporisation-condensation sur l'une ou les deux faces d'un dépôt contenant notamment de l'aluminium métallique et plus de 50% d'aluminium sous forme d'oxyde, l'épaisseur dudit dépôt étant comprise entre 100 et 10000 nanomètres et ledit dépôt étant constitué d'agglomérats de grains, les dits agglomérats formant une matrice poreuse d'oxyde d'aluminium contenant des cristallites d'aluminium métallique disposées de façon aléatoire à l'intérieur des grains.

Ainsi, par rapport à l'USP 4,309,810 où le dépôt se présente sous la forme d'un alignement de colonnes de cristaux de métal plus ou moins ramifiés, la présente invention montre au niveau du produit les différences suivantes :
- du point de vue composition, le dépôt n'est pas formé d'aluminium pur mais, d'un mélange dans lequel l'aluminium est à plus de 50% en poids sous forme d'oxyde ;
- du point de vue structure, le dépôt est constitué d'agglomérats de grains formant une matrice poreuse d'oxyde et dans ces grains sont dispersées des cristallites d'aluminium à la différence de l'art antérieur où le dépôt est constitué d'un ensemble de cristaux purement métalliques.

En outre, le dépôt obtenu présente une coloration pouvant aller du gris beige clair au noir profond.

Ce sont ces caractéristiques particulières du dépôt qui confèrent aux feuilles ainsi revêtues une capacité relativement très élevée.

De préférence, les agglomérats ont un diamètre moyen compris entre 100 et 1000 nanomètres ; les grains des agglomérats ont un diamètre moyen compris entre 10 et 50 nanomètres tandis que les cristallites qui sont insérées dans les dits grains ont un diamètre inférieur à celui des grains et de valeur moyenne comprise entre 1 et 20 nanomètres.

En effet, en dehors de ces fourchettes, les capacités obtenues bien que convenables sont moins bonnes et se dégradent à mesure qu'on s'écarte de leurs limites.

De préférence également, les grains sont disposés de façon telle qu'ils laissent entre eux un réseau ramifié de cavités communicantes de manière que le dépôt forme une masse poreuse où le volume des cavités est compris entre 20 et 50% du volume du dépôt.

Cette structure rend possible la pénétration complète de l'électrolyte, ce qui permet d'exploiter la totalité de la surface développée lors des opérations de formation et/ou de stabilisation et lors de l'utilisation finale dans le condensateur, d'où un fort niveau de capacité et une grande stabilité des performances dans le temps.

C'est ainsi qu'en particulier le traitement de stabilisation conduit à la présence dans tout le dépôt de composés inhibiteurs de l'oxydation ou de l'hydratation par les agents extérieurs, de préférence, des ions dérivés des composés oxygénés du phosphore.

En ce qui concerne le substrat conducteur de l'électricité, il appartient de préférence au groupe constitué par l'aluminium, un de ses alliages ou une matière plastique revêtue d'aluminium.

Ce conducteur se présente sous la forme d'une bande continue de largeur et d'épaisseur dépendants des dimensions du condensateur à fabriquer et sur l'une ou de préférence sur les deux faces de laquelle est effectué le dépôt selon l'invention.

L'invention comprend également un procédé permettant de réaliser le dépôt dont la composition et la structure ont été décrits plus haut.

Ce procédé est caractérisé en ce que l'on forme le dépôt par vaporisation d'aluminium puis condensation et solidification dans une atmosphère contenant de l'oxygène ou des composés oxygénés sur un substrat fixe ou mobile à l'intérieur d'une chambre où règne dans la zone de dépôt une pression comprise entre 2,8 et 0,3 Pa et suivant une vitesse de croissance en épaisseur comprise entre 0,03 et 0,2 micromètre par seconde pour une face.

Ainsi, le procédé selon l'invention consiste à effectuer le dépôt dans une atmosphère oxydante qui peut être constituée par de l'oxygène pur, un mélange gazeux contenant de l'oxygène ou des composés oxygénés. Le facteur important pour obtenir un dépôt de composition et de structure conformes à l'invention est la pression régnant dans la zone de dépôt, c'est-à-dire près du substrat et qui doit être comprise entre 2,8 et 0,3 Pa.

En effet, on a constaté qu'à une pression inférieure à 0,3 Pa, la valeur de la capacité spécifique diminuait rapidement du fait de la moindre quantité d'aluminium sous forme oxydée d'où une densification du dépôt et une diminution de la taille des grains déposés. De même, lorsque la pression dépasse 2,8 Pa, la capacité spécifique diminue également mais en raison cette fois d'un trop fort grossissement des grains.

Une autre caractéristique du procédé est la formation d'un dépôt d'une épaisseur comprise entre 100 et 10000 nanomètres suivant une vitesse sur l'une des faces relativement faible et comprise entre 0,03 et 0,2 micromètre par seconde et par face.

En effet, on a constaté également que cette vitesse avait une importance sur la capacité spécifique du fait qu'elle influencait le degré de ramification des cavités des grains. A faible vitesse, il se produit un rapide développement de la matrice d'oxyde et à grande vitesse, la densité du dépôt augmente en diminuant le volume des cavités et la surface développée du dépôt.

L'épaisseur du dépôt est fonction, pour une vitesse donnée, de la durée d'évaporation mais, de préférence, cette durée est inférieure à 100 secondes car quand la durée est supérieure à cette valeur, le dépôt obtenu est épais, fragile et présente des cavités bouchées qui réduisent la capacité.

Certes, la capacité spécifique s'accroît avec l'épaisseur du dépôt mais, en fait, on se limite à 10000 nanomètres car au delà, outre les risques de fragilisation du dépôt, le prix de revient de l'élaboration du dépôt deviendrait prohibitif.

En ce qui concerne l'atmosphère oxydante, elle est sans cesse renouvelée dans la chambre sous les actions combinées d'un pompage à l'aide d'une pompe à vide et d'une admission sous pression de gaz oxydant qui se conjuguent de manière à créer une circulation de gaz ayant un débit compris entre 1 et 100 l/h dans le cas d'un dépôt sur une seule face. En effet, en dessous de 1 l/h, les particules d'aluminium évaporées sont insuffisamment oxydées pour conduire à la structure recherchée tandis qu'au dessus de 100 l/h, la pression s'accroît dans la chambre en provoquant une diminution de la capacité du dépôt.

De préférence, le gaz oxydant est admis dans la chambre sous une pression comprise entre 0,002 et 0,04 MPa car en dehors de cette fourchette le dépôt obtenu n'a pas les caractéristiques convenables.

Dans ces conditions, la capacité après dépôt sur les deux faces peut atteindre 300.000 microfarads par dm.

En ce qui concerne la vaporisation de l'aluminium, elle peut être réalisée par chauffage d'aluminium solide au moyen de l'effet Joule, de l'induction, d'un bombardement d'électrons, ou encore de l'arc électrique.

Cependant, l'obtention d'un dépôt ayant une bonne capacité initiale n'est pas suffisante ; il faut encore que la dégradation de la performance obtenue, notamment du fait de l'hydratation ou de l'oxydation au contact des agents extérieurs, par exemple, l'humidité de l'air, soit limitée dans le temps.

C'est pourquoi, il est nécessaire de soumettre le dépôt préalablement formé ou non à un traitement de stabilisation chimique ou électrochimique qui, s'il provoque une perte par rapport à la capacité initiale de la feuille non stabilisée, permet ensuite de maintenir cette capacité dans le temps à cette nouvelle valeur.

Cette stabilisation s'obtient, de préférence, par immersion du substrat revêtu dans une solution aqueuse contenant des ions dérivés des composés oxygénés du phosphore et dans laquelle peut passer un courant électrique.

Dans le cas d'un traitement électrochimique, on effectue une anodisation de la feuille en utilisant une tension électrique qui dépend de l'application finale.

### DESSINS-

L'invention sera mieux comprise à l'aide des figures ci-jointes qui représentent :

Figure 1 : schématiquement, une coupe verticale d'un dispositif permettant de réaliser la feuille ( dépôt sur une face ).

Figure 2 : une micrographie obtenue par microscopie électronique à balayage de la tranche d'un dépôt.

Figure 3 : une micrographie obtenue par microscopie électronique à balayage de la surface externe d'un dépôt .

Figure 4 : une micrographie obtenue par microscopie électronique à transmission à haute résolution de la tranche d'un dépôt.

Figure 5 : une vue par microscopie à force atomique de la surface externe d'un dépôt.

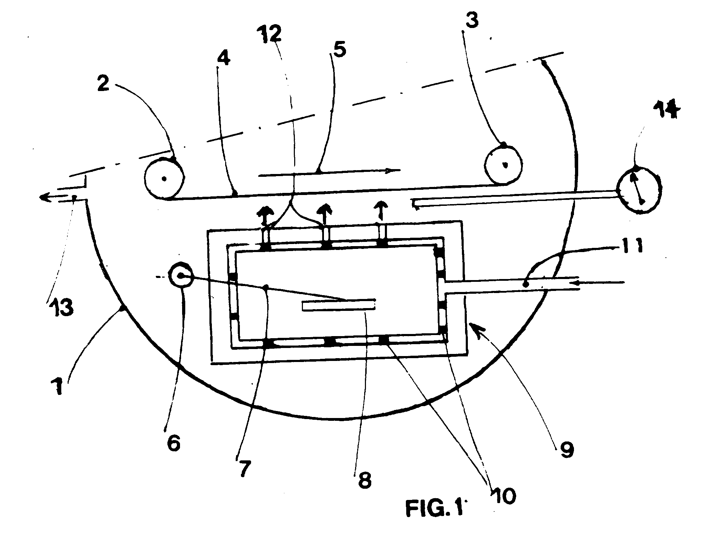

Sur la figure 1, on distingue une chambre 1 de dépôt à l'intérieur de laquelle sont placées une bobine dérouleuse 2 et une bobine enrouleuse 3 permettant au substrat 4 de se déplacer dans le sens de la flèche 5 au dessus du système d'évaporation thermique de l'aluminium comportant une alimentation 6 en fil d'aluminium 7 qui est fondu dans le creuset 8 chauffé par une source de chaleur non représentée et placé à l'intérieur d'une enceinte 9 munie d'ouvertures 10 par lesquelles arrive le gaz oxydant introduit sous pression par la tubulure 11 et de canaux 12 par lesquels s'échappe vers le substrat le mélange de vapeurs d'aluminium et de gaz oxydant ; une tuyauterie 13 placée sur la paroi de la chambre et reliée à un système de pompage non représenté permet de maintenir la pression convenable dans la zone de dépôt, pression qui est mesurée à l'aide du manomètre 14, et d'assurer la circulation du gaz suivant un débit mesuré sur la tubulure 11 avec un débitmètre non représenté.

Dans cette configuration, le dépôt s'effectue sur une seule face. Il est possible en installant un second creuset et en modifiant le système de déplacement du substrat d'effectuer le dépôt simultanément sur les deux faces.

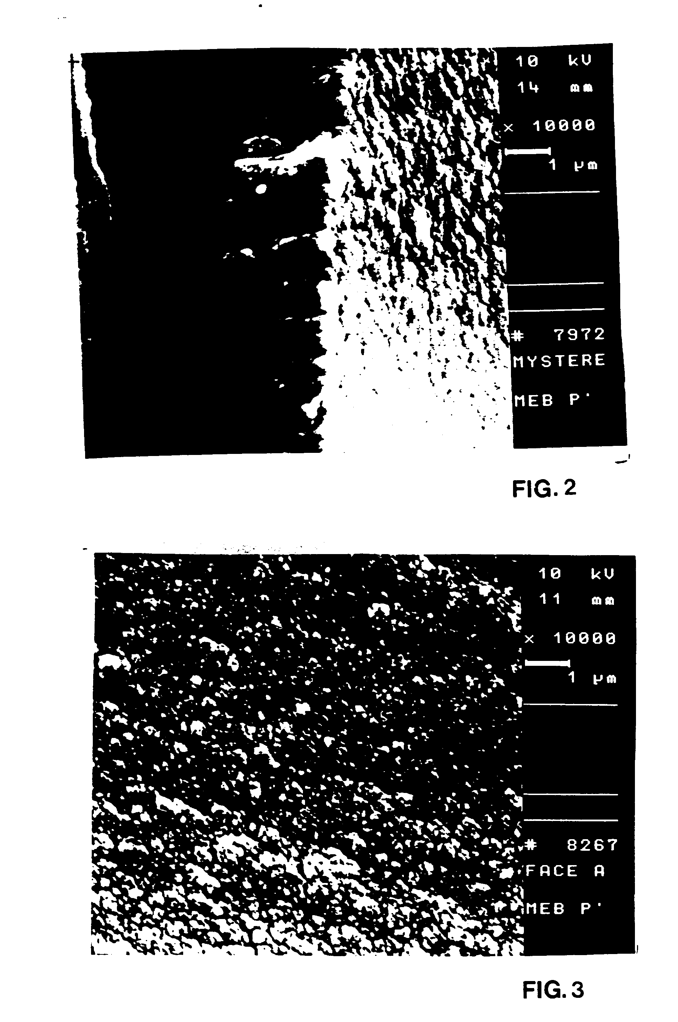

Sur la figure 2, on voit la tranche d'un dépôt d'une épaisseur de 2200 nanomètres qui est homogène, dont la morphologie de croissance montre des agglomérats de dimensions comprises entre 200 et 800 nanomètres.

Sur la figure 3 prise au grandissement 10000, on peut voir une surface où le contour des agglomérats a un diamètre moyen de 300 nanomètres.

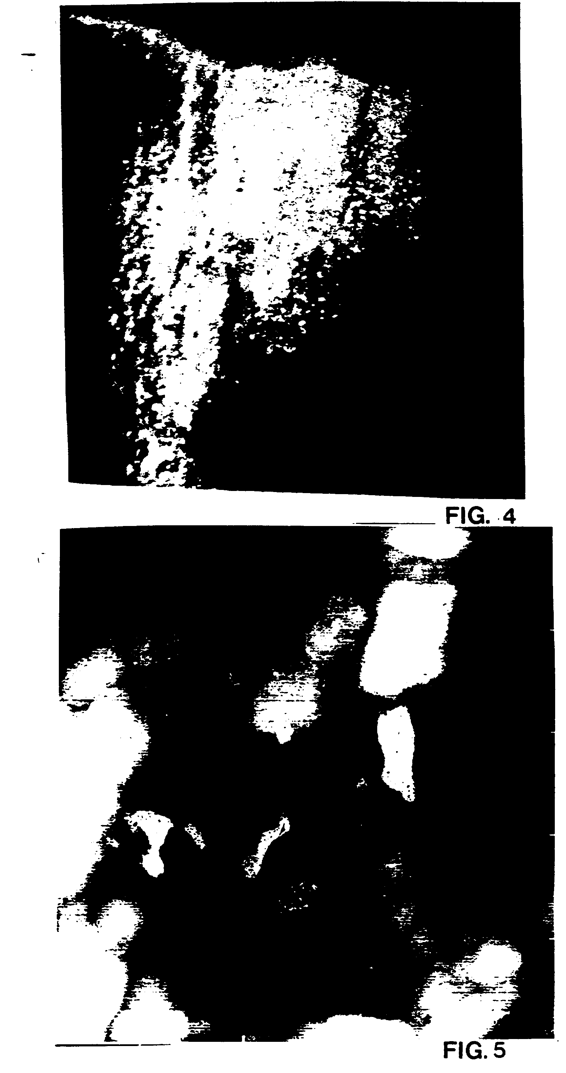

Sur la figure 4, prise sur un fragment de dépôt, on voit des cristallites d'aluminium d'un diamètre moyen de 3 nanomètres dispersées dans la masse d'aluminium oxydé.

Sur la figure 5, on voit une surface avec un champ imagé de 1 micromètre * 1 micromètre où apparaissent des grains de dimensions comprises entre 10 et 20 nanomètres.

### EXEMPLES D'APPLICATION.-

L'invention sera mieux comprise à l'aide des exemples suivants :

### EXEMPLE 1 :

Une feuille en aluminium à 99,5% en poids, d'épaisseur 30 micromètres, de largeur 300 mm , dégraissée après laminage a été traitée suivant l'invention dans les conditions suivantes :
- pression d'admission de l'oxygène : 0,005 MPa ;
- débit de gaz : 15 l/h ;
- pression dans la zone de dépôt : 1,2 Pa ;
- vitesse de dépôt : 0,08 micromètre/sec.;
- durée de dépôt : 30 secondes ;
- épaisseur du dépôt : 2,4 micromètres.

Après dépôt sur les deux faces, la feuille a été soumise à un traitement de stabilisation électrochimique anodique sous une tension de 1,7 volt dans une solution aqueuse contenant un mélange d'acide phosphorique et de phosphate d'ammonium.

Les observations par différentes techniques microscopiques ont révélé que la taille moyenne des grains est de 15 nanomètres et celle des cristallites de 3 nanomètres.

Le contrôle de la porosité effectué par mesure de la surface spécifique a montré que le volume des cavités est de 30% du volume total du dépôt.

La capacité de la feuille après un mois de vieillissement est de 180.000 microfarads/décimètre carré.

### EXEMPLE 2 :

Une feuille complexe formée par colaminage d'un film de polypropylène d'épaisseur 20 micromètres et de deux films en aluminium à 99,5% en poids, dégraissés, d'épaisseur 10 micromètres a été traitée suivant l'invention dans les conditions suivantes :
- pression d'admission de l'oxygène : 0,02 MPa ;
- débit de gaz : 70 l/h ;
- pression dans la zone de dépôt : 2 Pa ;
- vitesse de dépôt : 0,15 micromètre/sec. ;
- durée du dépôt : 10 secondes ;
- épaisseur du dépôt : 1,5 micromètre.

Après dépôt sur les deux faces et traitement de stabilisation identique à celui de l'exemple 1, on a observé la feuille avec les mêmes moyens que précédemment et on a mesuré :
- une taille moyenne des grains de 27 nanomètres ;
- une taille moyenne des cristallites en aluminium de 5 nanomètres ;
- un volume des cavités de 20% du volume total du dépôt.

La capacité de la feuille après un mois de vieillissement est de 80.000 microfarads/décimètre carré.

### EXEMPLE 3 :

Une feuille identique à celle de l'exemple 1 a été traitée suivant l'invention dans les conditions suivantes :
- pression d'admission de l'oxygène : 0,007 MPa ;
- débit de gaz : 20 l/h ;
- pression dans la zone de dépôt : 0,5 Pa ;
- vitesse de dépôt : 0,1 micromètre/sec. ;
- durée de dépôt : 100 secondes ;
- épaisseur du dépôt : 10 micromètres.

Après dépôt sur les deux faces et traitement de stabilisation identique à celui de l'exemple 1, on a observé la feuille avec les mêmes moyens que précédemment et on a mesuré :
- une taille moyenne des grains de 12 nanomètres ;
- une taille moyenne des cristallites d'aluminium de 2 nanomètres ;
- un volume des cavités de 35% du volume total du dépôt. La capacité de la feuille après un mois de vieillissement est de 250.000 microfarads/ décimètre carré.

Dans ces exemples, le substrat a été revêtu sur ses deux faces en deux passages successifs dans la chambre de dépôt, compte tenu de sa configuration.

L'invention trouve son application dans la confection de condensateurs de capacité spécifique élevée, ce qui permet une miniaturisation et une amélioration de leur prix de revient.

## Revendications

1. Feuille pour électrode de condensateur electrolytique formée d'un substrat conducteur de l'électricité optionnellement rendu rugueux, revêtu par vaporisation-condensation sur l'une ou les deux faces d'un dépôt contenant de l'aluminium métallique et plus de 50% d'aluminium sous forme d'oxyde, l'épaisseur dudit dépôt étant comprise entre 100 et 10000 nanomètres et ledit dépôt étant constitué d'agglomérats de grains, lesdits agglomérats formant une matrice poreuse d'oxyde d'aluminium contenant des cristallites d'aluminium métallique disposées de façon aléatoire à l'intérieur des grains.

2. Feuille selon la revendication 1, caractérisée en ce que les agglomérats ont un diamètre moyen compris entre 100 et 1000 nanomètres.

3. Feuille selon la revendication 1, caractérisée en ce que les grains ont un diamètre moyen compris entre 10 et 50 nanomètres.

4. Feuille selon la revendication 1, caractérisée en ce que les cristallites ont un diamètre inférieur à celui des grains dans lesquels les dites cristallites sont insérées, le dit diamètre ayant une valeur moyenne comprise entre 1 et 20 nanomètres.

5. Feuille selon la revendication 1, caractérisée en ce que les grains sont disposés de manière à laisser entre eux un réseau ramifié de cavités communicantes.

6. Feuille selon la revendication 1, caractérisée en ce que le volume des cavités est compris entre 20 et 50% du volume du dépôt.

7. Feuille selon la revendication 1, caractérisée en ce que le dépôt contient également des ions dérivés des composés oxygénés du phosphore.

8. Feuille selon la revendication 1, caractérisée en ce que le conducteur de l'électricité appartient au groupe constitué par l'aluminium, un de ses alliages, une matière plastique revêtue d'aluminium.

9. Procédé de fabrication d'une feuille selon la revendication 1, dans lequel on forme le dépôt par vaporisation d'aluminium puis condensation et solidification dans une atmosphère contenant de l'oxygène ou des composés oxygénés sur l'une ou les deux faces d'un substrat (4) fixe ou mobile à l'intérieur d'une chambre (1) où règne dans la zone de dépôt une pression comprise entre 2,8 et 0,3 Pa et suivant une vitesse de croissance en épaisseur comprise entre 0,03 et 0,2 micromètre par seconde pour une face.

10. Procédé selon la revendication 9, caractérisé en ce que la durée de condensation en un point du substrat est inférieure à 100 secondes.

11. Procédé selon la revendication 9, caractérisé en ce que l'atmosphère oxydante pénètre dans la chambre sous une pression comprise entre 0,002 et 0,04 MPa et un débit de 1 à 100 l/h dans le cas d'un dépôt sur une seule face.

12. Procédé selon la revendication 9, caractérisé en ce que la vaporisation de l'aluminium est réalisée par chauffage d'aluminium à l'aide d'un moyen appartenant au groupe constitué par l'effet Joule, l'induction, le bombardement d'électrons, l'arc électrique.

13. Procédé selon la revendication 9, caractérisé en ce que la feuille est soumise à un traitement de formation et/ou de stabilisation chimique ou électrochimique.

14. Procédé selon la revendication 13, caractérisé en ce que la stabilisation s'effectue en présence d'ions dérivés des composés oxygénés du phosphore.

## Patentansprüche

1. Elektrodenfolie für Elektrolytkondensator, die aus einem die Elektrizität leitenden, wahlweise aufgerauhten Substrat gebildet ist, das durch Verdampfung-Kondensation auf der einen oder beiden Flächen mit einer metallisches Aluminium und mehr als 50 % Aluminium in Oxidform enthaltenden Abscheidung bedeckt ist, deren Dicke im Bereich von 100 bis 10 000 nm liegt und die aus Körneragglomeraten besteht, die eine poröse Aluminiumoxidmatrix bilden, die in zufälliger Weise in Inneren der Körner verteilte Kristallite aus metallischem Aluminium enthält.

2. Folie nach dem Anspruch 1,
dadurch gekennzeichnet,
daß die Agglomerate einen mittleren Durchmesser im Bereich von 100 bis 1000 nm haben.

3. Folie nach dem Anspruch 1,
dadurch gekennzeichnet,
daß die Körner einen mittleren Durchmesser im Bereich von 10 bis 50 nm haben.

4. Folie nach dem Anspruch 1,
dadurch gekennzeichnet,
daß die Kristallite einen kleineren Durchmesser als den der Körner haben, in denen die Kristallite eingefügt sind, wobei der Durchmesser einen mittleren Wert im Bereich von 1 bis 20 nm hat.

5. Folie nach dem Anspruch 1,
dadurch gekennzeichnet,
daß die Körner derart angeordnet sind, daß sie zwischen sich ein verzweigtes Netz in Verbindung stehender Hohlräume belassen.

6. Folie nach dem Anspruch 5,
dadurch gekennzeichnet,
daß das Volumen der Hohlräume im Bereich von 20 bis 50 % des Volumens der Abscheidung ist.

7. Folie nach dem Anspruch 1,
dadurch gekennzeichnet,
daß die Abscheidung auch von sauerstoffhaltigen Verbindungen des Phosphors abgeleitete Ionen enthält.

8. Folie nach dem Anspruch 1,
dadurch gekennzeichnet,
daß der Leiter der Elektrizität zu der aus Aluminium, einer seiner Legierungen und einem mit Aluminium beschichteten Kunststoff gebildeten Gruppe gehört.

9. Verfahren zur Herstellung einer Folie nach dem Anspruch 1, bei dem man die Abscheidung durch Aluminiumverdampfung, danach -kondensation und -erstarrung in einer Sauerstoff oder sauerstoffhaltige Verbindungen enthaltenden Atmosphäre auf der einen oder den beiden Oberflächen eines festen oder beweglichen Substrats (4) im Inneren einer Kammer (1), wo in der Abscheidungszone ein Druck im Bereich von 2,8 bis 0,3 Pa herrscht, und entsprechend einer Dickenwachstumsgeschwindigkeit im Bereich von 0,03 bis 0,2 µm je Sekunde für eine Oberfläche bildet.

10. Verfahren nach dem Anspruch 9,
dadurch gekennzeichnet,
daß die Kondensationsdauer an einem Punkt des Substrats unter 100 Sekunden ist.

11. Verfahren nach dem Anspruch 9,
dadurch gekennzeichnet,
daß die oxidierende Atmosphäre in die Kammer mit einem Druck im Bereich von 0,002 bis 0,04 MPa und einem Durchsatz von 1 bis 100 l/h im Fall einer Abscheidung auf nur einer Oberfläche eindringt.

12. Verfahren nach dem Anspruch 9,
dadurch gekennzeichnet,
daß die Verdampfung des Aluminiums durch Erhitzen von Aluminium mit Hilfe eines zur durch den Joule-Effekt, die Induktion, den Elektronenbeschuß und den elektrischen Lichtbogen gebildeten Gruppe gehörenden Mittels vorgenommen wird.

13. Verfahren nach dem Anspruch 9,
dadurch gekennzeichnet,
daß die Folie einer Behandlung zur chemischen oder elektrochemischen Formierung und/oder Stabilisierung unterworfen wird.

14. Verfahren nach dem Anspruch 13,
dadurch gekennzeichnet,
daß die Stabilisierung in Gegenwart von aus sauerstoffhaltigen Phosphorverbindungen abgeleiteten Ionen erfolgt.

## Claims

1. Plate for an electrode of an electrolytic capacitor formed from an electrically conductive substrate, optionally roughened, coated by vaporisation-condensation on one or on both faces with a deposit containing metallic aluminium and more than 50% of aluminium in the form of an oxide, the thickness of said deposit being between 100 and 10,000 nanometres and said deposit being constituted by agglomerates of grains, said agglomerates forming a porous matrix of aluminium oxide containing metallic aluminium crystallites randamly arrangeg manner in the interior of the grains.

2. Plate according to claim 1, characterised in that the agglomerates have an average diameter of between 100 and 1,000 nanometres.

3. Plate according to claim 1, characterised in that the grains have an average diameter of between 10 and 50 nanometres.

4. Plate according to claim 1, characterised in that the crystallites have a diameter less than that of the grains in which said crystallites are embedded, said diameter having an average value of between 1 and 20 nanometres.

5. Plate according to claim 1, characterised in that the grains are arranged such as to leave a crosslinked network of communicating cavities in between them.

6. Plate according to claim 1, characterised in that the volume of the cavities is between 20 and 50% of the volume of the deposit.

7. Plate according to claim 1, characterised in that the deposit also contains ions derived from oxygenated compounds of phosphorus.

8. Plate according to claim 1, characterised in that the electrical conductor belongs to the group constituted by aluminium, one of the alloys thereof, or a plastics material coated with aluminium.

9. Method of manufacture of a plate according to claim 1, in which the deposit is formed by vaporisation of aluminium, then condensation and solidification, in an atmosphere containing oxygen or oxygenated compounds, on one or both faces of a substrate (4) which is fixed or moveable inside a chamber (1) where there is prevailing a pressure in the deposition area of between 2.8 and 0.3 Pa, and according to an increase in thickness of between 0.03 and 0.2 micrometres per second for one face.

10. Method according to claim 9, characterised in that the duration of condensation on one point of the substrate is less than 100 seconds.

11. Method according to claim 9, characterised in that the oxidising atmosphere penetrates into the chamber at a pressure of between 0.002 and 0.04 MPa and at a rate of 1 to 100 l/h in the case of deposition on one face only.

12. Method according to claim 9, characterised in that the vaporisation of the aluminium is carried out by heating of the aluminium using a means belonging to the group constituted by the Joule effect, induction, electron bombardment and electric arc.

13. Method according to claim 9, characterised in that the plate is subjected to a chemical or electrochemical formation and/or stabilisation treatment.

14. Method according to claim 13, characterised in that the stabilisation takes place in the presence of ions derived from oxygenated compounds of phosphorus.
